# EUROPÄISCHE PATENTSCHRIFT

(11) **EP 0 689 098 B1**
(45) Veröffentlichungstag und Bekanntmachung des Hinweises auf die Patenterteilung: **16.08.2000**
(21) Anmeldenummer: 95810395.4
(22) Anmeldetag: 13.06.1995
(51) Int. Cl.: G03F 7/039

(54) **Positiv-Photoresist**
Positive working photoresist
Photoréserve positive

(30) Priorität: 22.06.1994 CH 199294; 18.01.1995 CH 13895
(43) Veröffentlichungstag der Anmeldung: 27.12.1995
(73) Patentinhaber: Ciba Specialty Chemicals Holding Inc., 4057 Basel (CH)
(72) Erfinder: Tang, Qian, Dr., CH-4104 Oberwill (CH); Roth, Martin, Dr., CH-4434 Hölstein (CH)

(56) Entgegenhaltungen:
- EP-A- 0 454 334
- EP-A- 0 488 525
- EP-A- 0 601 974
- US-A- 5 252 427
- US-A- 5 262 281
- PATENT ABSTRACTS OF JAPAN vol. 17 no. 291 (C-1067) ,4.Juni 1993 & JP-A-05 017711 (HITACHI CHEM. CO. , LTD.) 26.Januar 1993,

## Beschreibung

Die vorliegende Erfindung betrifft eine wässrig-alkalisch entwickelbare Positiv-Photoresist-Zusammensetzung und ein Verfahren zur Herstellung von Reliefstrukturen unter Verwendung dieser Photoresist-Zusammensetzung.

Bei der lithographischen Herstellung von Reliefstrukturen auf diversen Substraten werden häufig Ätzresists verwendet, die ein Bindemittel mit säureempfindlichen Gruppen und einen Photosäuregenerator enthalten.

In der JP-Kokai Hei 02-248952 werden Photoresistzusammensetzungen auf Basis von phenolischen Harzen, deren Hydroxygruppen vollständig oder teilweise durch Tetrahydropyranylethergruppen substituiert sind, beschrieben, die sich durch ein hohes Auflösungsvermögen auszeichnen. Ein Nachteil dieser Zusammensetzungen ist jedoch die nach der Belichtung erforderliche Hitzebehandlung.

Die JP-Kokai Hei 05-17711 offenbart eine Ätzresistzusammensetzung enthaltend ein Copolymer aus (Meth)acrylsäure, Tetrahydropyranyl(meth)acrylat und einem Alkylacrylat und einen Photosäuregenerator. Diese Zusammensetzung wird mittels Elektrotauchlackierung auf dem Substrat abgeschieden, wobei ein Film von hoher Homogenität erhalten wird. Allerdings ist die Photoempfindlichkeit dieses Resists relativ niedrig. Ausserdem ist auch bei diesem Verfahren eine Hitzebehandlung nach der Belichtung erforderlich.

Im US-Patent 5,252,427 werden Copolymere beschrieben, die sowohl säureempfindliche Gruppen als auch freie Säuregruppen enthalten, und in Kombination mit üblichen Photosäurebildnern als Ätzresists verwendet werden können. Die thermische Stabilität sowohl der Copolymeren als auch der daraus hergestellten Beschichtungen ist jedoch für gewisse Anwendungen unzureichend.

Auch die in der EP-A 568 827 beschriebenen Mischungen von Copolymeren enthaltend säureempfindliche Gruppen und Copolymeren enthaltend freie Säuregruppen können in Kombination mit üblichen Photosäuregeneratoren als Basisharze für Positiv-Photoresists eingesetzt werden. Von Nachteil sind auch bei diesen Photoresists die relativ niedrige Photoempfindlichkeit und die nach der Bestrahlung erforderliche Hitzebehandlung.

Es wurde nun gefunden, dass bei Verwendung von Mischungen aus spezifischen organischen Homo- oder Copolymeren Photoresistmaterialien mit hoher Photoempfindlichkeit erhalten werden, die keine thermische Nachbehandlung benötigen, eine hohe Lagerstabilität aufweisen und gut aufgelöste Reliefstrukturen liefern.

Gegenstand der vorliegenden Erfindung ist eine wässrig-alkalisch entwickelbare Positiv-Photoresist-Zusammensetzung enthaltend
(a) mindestens ein Homo- oder Copolymer enthaltend 8-100 Gew.-% wiederkehrende Strukturelemente der Formel Ia und 92-0 Gew.-% wiederkehrende Strukturelemente der Formel Ib 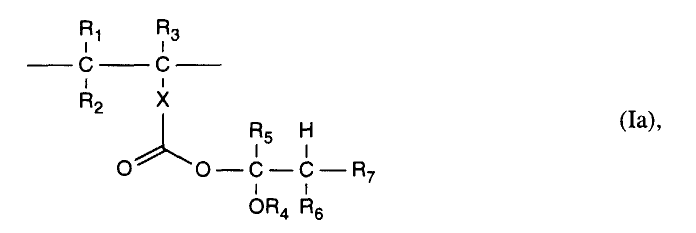 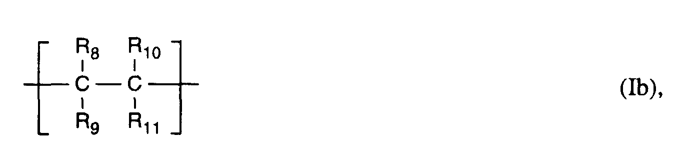 worin X für eine direkte Bindung oder eine zweiwertige organische Gruppe mit 1-18 C-Atomen steht, wobei ein oder mehrere C-Atome durch Sauerstoff-, Schwefel- oder nicht-basische Stickstoff-Atome ersetzt sein können,
   R₁, R₂ und R₃ unabhängig voneinander Wasserstoff, C₁-C₆-Alkyl, C₅-C₁₄-Aryl, C₆-C₂₀-Aralkyl, Halogen, -COOH, -COOR₁₂ oder -CONR₁₃R₁₄ bedeuten, wobei R₁₂ für eine unsubstituierte oder eine mit C₁-C₆-Alkoxy, Hydroxy oder Halogen substituierte C₁-C₁₈-Alkylgruppe oder den Rest eines hydroxyterminierten Polyethers oder Polyesters steht, R₁₃ und R₁₄ unabhängig voneinander Wasserstoff, C₁-C₁₈-Alkyl, C₅-C₁₄-Aryl oder C₆-C₂₀-Aralkyl bedeuten,
   R₄ C₁-C₆-Alkyl oder Phenyl darstellt,
   R₅ Wasserstoff oder C₁-C₆-Alkyl ist und
   R₆ und R₇ unabhängig voneinander Wasserstoff, C₁-C₆-Alkyl oder C₁-C₆-Alkoxy darstellen,
   oder zwei der Reste R₄, R₅, R₆ oder R₇ zusammen mit den C- oder O-Atomen, an die sie gebunden sind, einen Ring mit 5-8 Ringgliedern bilden,
   R₈, R₉ , R₁₀ und R₁₁ unabhängig voneinander Wasserstoff, C₁-C₁₈-Alkyl, unsubstituiertes oder mit C₁-C₆-Alkyl, C₁-C₆-Alkoxy oder Halogen substituiertes Phenyl, Halogen, C₁-C₁₈-Alkoxy, -COOR₁₂, -OCOR₁₂ oder -COOH bedeuten, worin R₁₂ die oben angegebene Bedeutung hat,
   oder R₉ und R₁₁ zusammen mit den C-Atomen, an die sie gebunden sind, einen fünfgliedrigen Ring der Struktur 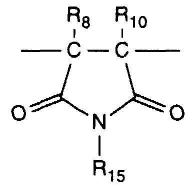 bilden, worin R₁₅ Wasserstoff, C₁-C₁₈-Alkyl, C₅-C₁₄-Aryl, C₆-C₂₀-Aralkyl oder hydroxy-, alkoxy- oder halogensubstituiertes Phenyl bedeutet,
   mit der Massgabe, dass das mittlere Molekulargewicht (Gewichtsmittel) des Homo- oder Copolymeren 1000-500000 und die Menge an COOH-Gruppen höchstens 0,4 mol/kg beträgt,
(b) mindestens ein Carbonsäuregruppen enthaltendes Copolymer, worin der Gehalt an Carbonsäuregruppen 0,40 bis 5,50 mol/kg beträgt,
(c) mindestens eine unter der Einwirkung von aktinischer Strahlung säurebildende Verbindung und
(d) ein organisches Lösungsmittel.

Der zweiwertige Rest X kann für einen beliebigen zweiwertigen aliphatischen, cycloaliphatischen, aromatischen, araliphatischen oder heterocyclischen Rest mit 1-18 C-Atomen stehen und kann gegebenenfalls Heteroatome, wie O, N oder S, oder funktionelle Gruppen, wie Carbonylgruppen oder Estergruppen, enthalten.

Unter nicht-basischen Stickstoff-Atomen sind quaternisierte Stickstoff-Atome oder Stickstoff-Atome mit elektronegativen Substituenten, wie beispielsweise Carbonylgruppen, zu verstehen.

Durch einen oder mehrere der Reste R₁ bis R₁₂ dargestellte Alkyl- oder Alkoxygruppen oder Alkyl- oder Alkoxygruppen als Substituenten von Phenylgruppen können geradkettig oder verzweigt sein. Als Beispiele seien genannt: Methyl, Ethyl, n-Propyl, i-Propyl, n-Butyl, sec.-Butyl, tert.-Butyl, n-Pentyl, neo-Pentyl, n-Hexyl, 2-Ethylhexyl, Methoxy, Ethoxy, n-Propoxy, i-Propoxy, n-Butoxy, sec.-Butoxy, tert.-Butoxy, n-Pentoxy, neo-Pentoxy und n-Hexoxy.

Halogenatome als Substituenten sind vorzugsweise Brom- oder Chloratome.

In der Formel Ia bedeuten R₁ und R₂ vorzugsweise Wasserstoff, und R₃ steht für Wasserstoff oder Methyl.

Besonders bevorzugt als Komponente (a) sind Homo- oder Copolymere enthaltend wiederkehrende Strukturelemente der Formel III 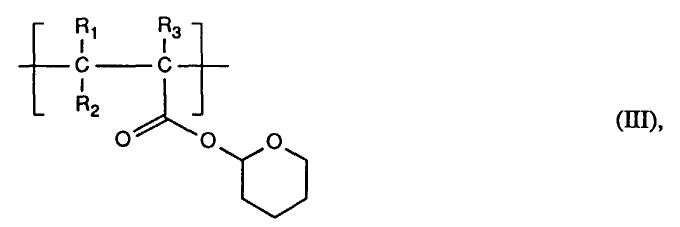 worin R₁, R₂ und R₃ unabhängig voneinander Wasserstoff, C₁-C₆-Alkyl, Phenyl oder Halogen bedeuten.

Insbesondere bevorzugt als Komponente (a) sind Homo- oder Copolymere enthaltend wiederkehrende Strukturelemente der Formel III, worin R₁ und R₂ Wasserstoff bedeuten und R₃ für Wasserstoff oder Methyl steht.

Die Komponente (b) ist vorzugsweise ein Homo- oder Copolymer enthaltend 5-40 Gew.-% wiederkehrende Struktureinheiten der Formel IIa und 95-60 Gew.-% wiederkehrende Struktureinheiten der Formel IIb 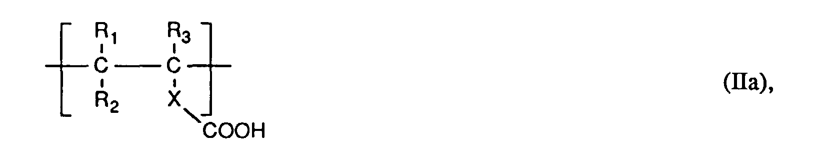 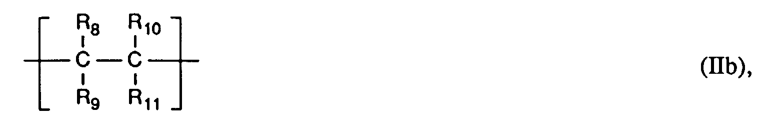 worin X für eine direkte Bindung oder eine zweiwertige organische Gruppe mit 1-18 C-Atomen steht, wobei ein oder mehrere C-Atome durch Sauerstoff-, Schwefel- oder nicht-basische Stickstoff-Atome ersetzt sein können,
R₁, R₂ und R₃ unabhängig voneinander Wasserstoff, C₁-C₆-Alkyl, C₅-C₁₄-Aryl, C₆-C₂₀-Aralkyl, Halogen, -COOH, -COOR₁₂ oder -CONR₁₃R₁₄ bedeuten, wobei R₁₂ für eine unsubstituierte oder eine mit C₁-C₆-Alkoxy, Hydroxy oder Halogen substituierte C₁-C₁₈-Alkylgruppe oder den Rest eines hydroxyterminierten Polyethers oder Polyesters steht, R₁₃ und R₁₄ unabhängig voneinander Wasserstoff, C₁-C₁₈-Alkyl, C₅-C₁₄-Aryl oder C₆-C₂₀-Aralkyl bedeuten, R₄ C₁-C₆-Alkyl oder Phenyl darstellt,
R₅ Wasserstoff oder C₁-C₆-Alkyl ist und
R₆ und R₇ unabhängig voneinander Wasserstoff, C₁-C₆-Alkyl oder C₁-C₆-Alkoxy darstellen,
oder zwei der Reste R₄, R₅, R₆ oder R₇ zusammen mit den C- oder O-Atomen, an die sie gebunden sind, einen Ring mit 5-8 Ringgliedern bilden,
R₈, R₉, R₁₀ und R₁₁ unabhängig voneinander Wasserstoff, C₁-C₁₈-Alkyl, unsubstituiertes oder mit C₁-C₆-Alkyl, C₁-C₆-Alkoxy oder Halogen substituiertes Phenyl, Halogen, C₁-C₁₈-Alkoxy, -COOR₁₂, -OCOR₁₂ oder -COOH bedeuten, worin R₁₂ die oben angegebene Bedeutung hat,
oder R₉ und R₁₁ zusammen mit den C-Atomen, an die sie gebunden sind, einen fünfgliedrigen Ring der Struktur 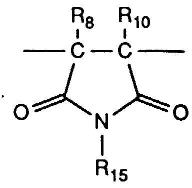 bilden, worin R₁₅ Wasserstoff, C₁-C₁₈-Alkyl, C₅-C₁₄-Aryl, C₆-C₂₀-Aralkyl oder hydroxy-, alkoxy- oder halogensubstituiertes Phenyl bedeutet,
mit der Massgabe, dass das mittlere Molekulargewicht des Copolymeren (Gewichtsmittel) 1000-500000 Dalton und der Gehalt an Carbonsäuregruppen 0,40 bis 5,50 mol/kg beträgt.

Vorzugsweise wird als Komponente (b) ein Homo- oder Copolymer enthaltend wiederkehrende Struktureinheiten der Formel (IIa) eingesetzt, worin R₁ und R₂ Wasserstoff bedeuten, R₃ für Wasserstoff oder Methyl steht und X eine direkte Bindung ist.

In den Struktureinheiten der Formel IIb bedeuten R₈ und R₉ vorzugsweise Wasserstoff, R₁₀ steht für Wasserstoff oder Methyl, und R₁₁ bedeutet vorzugsweise Phenyl oder -COOR₁₂, worin R₁₂ für C₁-C₁₈-Alkyl. Weiterhin bevorzugt sind Copolymere enthaltend wiederkehrende Struktureinheiten der Formel 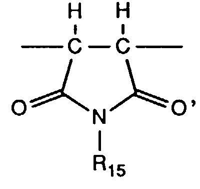 worin R₁₅ für Phenyl steht.

Die Homo- oder Copolymeren gemäss Komponente (a) und (b) können auf bekannte Weise durch anionische, kationische oder Gruppentransfer-Polymerisation oder insbesondere durch radikalische Polymerisation der entsprechenden ungesättigten Monomeren hergestellt werden.
Die radikalische Polymerisation bzw. Copolymerisation kann unter Anwendung verschiedener Techniken durchgeführt werden. Diese sind beispielsweise von S. Sandler und W. Karo in "Polymer Synthesis", Vol. 1, S. 3-17, 1968, Academic Press, New York, beschrieben worden. Übliche Polymerisationsverfahren sind beispielsweise die Polymerisation in der Masse oder in Lösungsmitteln, ferner die Emulsions-, Suspension- oder Fällungspolymerisation.
Das Molekulargewicht kann gegebenenfalls durch Zugabe kleiner Mengen eines Reglers eingestellt werden.

Die Polymerisation wird in der Regel durch einen üblichen Radikalstarter initiert. Dazu zählen thermische Initiatoren, wie Azoverbindungen, beispielsweise α,α'-Azoisobutyronitril (AIBN), oder Peroxide, beispielsweise Benzoylperoxid, oder Redoxinitiatorsysteme, wie eine Mischung von Eisen(III)acetyl-acetonat, Benzoin und Benzoylperoxid, oder photochemische Radikalbildner, wie Benzoin oder Benzildimethylketal.

Die Polymerisation wird bevorzugt in Lösung durchgeführt. Die Reaktionstemperatur bewegt sich im allgemeinen im Bereich von 10 bis 200°C, vorzugsweise zwischen 40 und 150°C, besonders bevorzugt zwischen 40 und 100°C.

Gegebenenfalls anwesende Lösungsmittel müssen unter den Reaktionsbedingungen inert sein. Als Lösungsmittel kommen u.a. aromatische Kohlenwasserstoffe, chlorierte Kohlenwasserstoffe, Alkohole, Ketone und Ether in Betracht. Beispiele hierfür sind: Benzol, Toluol, Xylole, Ethylbenzol, Isopropylbenzol, Ethylenchlorid, Propylenchlorid, Methylenchlorid, Chloroform, Methylethylketon, Aceton, Methoxypropylacetat, Isopropanol, Cyclohexanon, Diethylether oder Tetrahydrofuran.

Beispiele für geeignete Monomere zur Herstellung von Homo- oder Copolymeren enthaltend säurelabile α-Alkoxyalkylestergruppen sind 1-Ethoxyethylacrylat, -methacrylat oder -p-vinylbenzoat, 1-Butoxyethylacrylat, -methacrylat oder -p-vinylbenzoat, 1-Ethoxy-1-propylacrylat, -methacrylat oder -p-vinylbenzoat, Tetrahydropyranyloxy-acrylat, -methacrylat oder -p-vinylbenzoat.

Besonders bevorzugt sind Tetrahydropyranylacrylat und -methacrylat.

Die Monomeren enthaltend säurelabile α-Alkoxyalkylestergruppen können homopolymerisiert oder aber mit einem oder mehreren weiteren Monomeren copolymerisiert werden.

Geeignete Monomere zur Herstellung der Copolymeren sind beispielsweise Ethylen, Propylen, Styrol, Vinylchlorid, Vinylacetat, Acryl- oder Methacrylsäure, Methylacrylat oder -methacrylat, Ethylacrylat oder -methacrylat, Butylacrylat oder -methacrylat, Benzylacrylat oder -methacrylat, 2-Ethylhexylacrylat oder -methacrylat, 2-Hydroxyethylacrylat oder -methacrylat.

Vorzugsweise werden Methylacrylat, Methylmethacrylat, Ethylacrylat, Butylacrylat, Benzylmethacrylat, 2-Ethylhexylmethacrylat und 2-Hydroxyethylmethacrylat verwendet.

Die carbonsäuregruppenhaltigen Homo- oder Copolymeren gemäss Komponente (b) können analog durch radikalische Polymerisation der entsprechenden ungesättigten Carbonsäuren hergestellt werden.

Beispiele für geeignete Carbonsäuren sind Maleinsäure, Itaconsäure, Zimtsäure, Crotonsäure, p-Vinylbenzoesäure und insbesondere Acrylsäure und Methacrylsäure.

Die ungesättigten Carbonsäuren können mit einem oder mehreren weiteren Monomeren, wie beispielsweise Ethylen, Propylen, Styrol, Vinylchlorid, Vinylacetat, Methylacrylat oder -methacrylat, Ethylacrylat oder -methacrylat, Butylacrylat oder -methacrylat, Benzylacrylat oder -methacrylat, 2-Ethylhexylacrylat oder -methacrylat, 2-Hydroxyethylacrylat oder -methacrylat oder N-Phenylmaleinimid copolymerisiert werden.

Bevorzugte Comonomere sind Methylacrylat, Methylmethacrylat, Ethylacrylat, Butylacrylat, Benzylmethacrylat, tert.-Butylacrylat, tert.-Butylmethacrylat, 2-Ethylhexylmethacrylat und N-Phenylmaleinimid..

Bevorzugte erfindungsgemässe Zusammensetzungen enthalten als Komponente (a) mindestens ein Homo- oder Copolymer enthaltend 20-100 Gew.-%, insbesondere 30-100 Gew.-%, wiederkehrende Strukturelemente der Formel Ia und 80-0 Gew.-%, insbesondere 70-0 Gew.-%, wiederkehrende Strukturelemente der Formel Ib.

Die erfindungsgemässen Zusammensetzungen enthalten vorzugsweise als Komponente (b) mindestens ein Copolymer enthaltend 5-35 Gew.-%, insbesondere 10-30 Gew.-%, wiederkehrende Struktureinheiten der Formel IIa und 95-65 Gew.-%, insbesondere 90-70 Gew.-%, wiederkehrende Struktureinheiten der Formel IIb.

Das Mengenverhältnis der Komponenten (a) und (b) kann in weiten Bereichen variieren. Vorzugsweise enthalten die erfindungsgemässen Zusammensetzungen 10-95 Gew.-%, insbesondere 20-80 Gew.-%, der Komponente (a) und 90-5 Gew.-%, insbesondere 80-20 Gew.-%, der Komponente (b), bezogen auf die Summe der Komponenten (a) + (b).

Als Komponente (c) können im Prinzip alle dem Fachmann in der Resisttechnologie bekannten Verbindungen, die unter der Einwirkung von aktinischer Strahlung Säure bilden, eingesetzt werden, wie beispielsweise Onium-Salze, Disulfone, Eisen-Aren-Komplexe, Verbindungen mit photolabilen Halogenatomen (z.B. Halogenmethyl-triazine, Tetrabromkohlenstoff usw.), Sulfonsäureester, wie beispielsweise Sulfonsäurenitrobenzylester, Oximsulfonate α-Sulfonyloxyketone, N-Hydroxyimidsulfonate und N-Hydroxyamidsulfonate.

Geeignete Photoinitiatoren sind zum Beispiel in der EP-A 451 741 und der EP-A 568 827 beschrieben.

Vorzugsweise werden als Komponente (c) photoempfindliche Diazonium-, Sulfonium-, Sulfoxonium- oder Iodoniumsalze oder ein photoempfindlicher Sulfonsäureester eingesetzt.

Besonders bevorzugte Komponenten (c) sind Triphenylsulfoniumtrifluormethansulfonat, Triphenylsulfoniumhexafluoroantimonat, Triphenylsulfoniumhexafluorophosphat, Triphenylsulfoniumhexafluoroantimonat oder ein Hexafluorophosphat oder Hexafluoroantimonat der folgenden Sulfonium-Ionen: 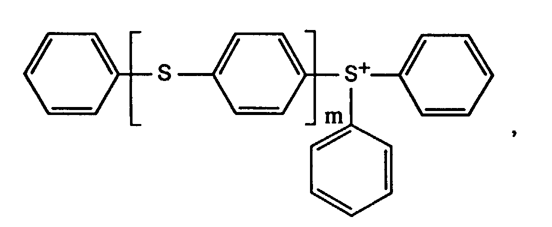 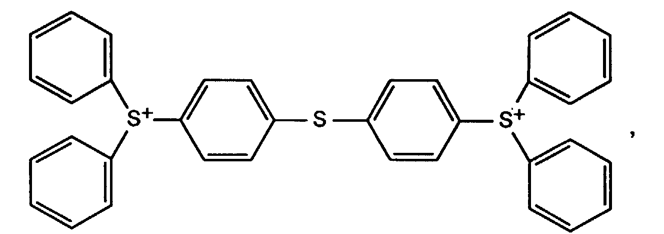 worin m für eine ganze Zahl von 1 bis 10 steht.

Die Komponente (c) wird im allgemeinen in einer Menge von 1-20 Gew.-%, vorzugsweise 2-10 Gew.-%, bezogen auf die Summe der Komponenten (a) + (b) eingesetzt.

Falls zweckmässig, können den erfindungsgemässen Zusammensetzungen Sensibilisatoren hinzugefügt werden, die die spektrale Empfindlichkeit des Photoinitiatorsystems bei der gewünschten Wellenlänge erhöhen. Die Wahl des geeigneten Sensibilisators hängt im wesentlichen vom gewählten Photoinitiator ab. So zeigen beispielsweise Sulfonium- und Iodoniumsalze nur bei Wellenlängen <350 nm eine ausreichende Photoempfindlichkeit. Die Empfindlichkeit solcher Verbindungen bei höheren Wellenlängen kann zum Beispiel durch Zusatz von aromatischen Kohlenwasserstoffen, wie Perylen, Pyren, Anthracen und deren Derivate, Phenothiazin bzw. Phenothiazinderivaten, unsubstituiertem oder substituiertem Thioxanthon wesentlich erhöht werden. Auch die z.B. im US-Patent 4,755,450 offenbarten Aminoarylketone eignen sich als Sensibilisatoren für Sulfonium- und Iodoniumsalze. Weitere geeignete Sensibilisatoren sind die aus dem US-Patent 4,162,162 bekannten Arylidenarylketone.

Die erfindungsgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher.

Zur Erhöhung der Lagerstabilität kann es zweckmässig sein, den erfindungsgemässen Zusammensetzungen geringe Mengen an schwach basischen Additiven hinzuzufügen. Geeignete basische Verbindungen sind z.B. primäre, sekundäre und tertiäre aliphatische, cycloaliphatische und aromatische Amine sowie N-Heterocyclen.
Als Beispiele seien genannt:
Triethylamin, Tripropylamin, Tributylamin, Anilin, N-Methylanilin, N,N-Dimethylanilin, 1-Naphthylamin, 2-Naphthylamin, Diphenylamin, Ethylendiamin, Hexamethylendiamin, 4,4'-Diaminodiphenylmethan, 4,4'-Diaminodiphenylether, 4,4'-Diaminobenzophenon, 4,4'-Diaminodiphenylamin, Pyrrolidin und -derivate, Piperidin und -derivate, Imidazol und -derivate, wie beispielsweise 4-Methylimidazol, 4-Methyl-2-phenylimidazol, 4,5-Diphenylimidazol und insbesondere 1-Methylimidazol.

Die zweckmässig zu verwende Menge der basischen Additive hängt im wesentlichen von der Menge des Photosäuregenerators (c) ab. Vorzugsweise werden 0,01-5,0 mmol, insbesondere 0,02-2,0 mmol, basisches Additiv pro Gramm Photosäuregenerator eingesetzt.

Eine stabilisierende Wirkung wird auch erzielt, wenn die Polymeren gemäss Komponente (a) und/oder (b) geringe Mengen basischer Substituenten, wie z.B. Aminogruppen, aufweisen. Zur Herstellung solcher Polymeren wird bei der radikalischen Polymerisation der ungesättigten Ausgangsmonomeren eine kleine Menge an ungesättigten Monomeren mit basischen Substituenten zugegeben. Geeignete Monomere mit basischen Substituenten sind beispielsweise mit Aminogruppen substituierte Acrylate, wie 2-Dimethylaminoethylacrylat, 2-Dimethylaminoethylmethacrylat, 2-Diethylaminoethylacrylat, 2-Diethylaminoethylmethacrylat, Dimethylaminopropylacrylamid, Dimethylaminopropylmethacrylamid, 2-t-Butylaminoethylacrylat, 2-t-Butylaminoethylmethacrylat, oder Vinylpyridine, wie 2-Vinylpyridin oder 4-Vinylpyridin.

Die zweckmässig einzusetzende Menge solcher Comonomeren mit basischen Substituenten hängt im wesentlichen von der Menge des Photosäuregenerators (c) ab. Vorzugsweise werden 0,01-5,0 mmol, insbesondere 0,02-2,0 mmol, Comonomer mit basischen Substituenten pro Gramm Photosäuregenerator eingesetzt.

Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder enfernt werden können. Geeignete Lösungsmittel sind z.B. Ketone, Ether und Ester, wie Methylethylketon, 2-Heptanon, Cyclopentanon, Cyclohexanon, γ-Butyrolacton, Ethylpyruvat, Diethylenglykol-dimethylether, 2-Methoxyethanol, 2-Ethoxyethanol, 2-Ethoxyethylacetat, 1-Methoxy-2-propylacetat, 1,2-Dimethoxyethan, Essigsäureethylester und 3-Methoxymethylpropionat.

Bevorzugtes Lösungsmittel ist Methoxypropylacetat.

Der Festkörpergehalt der Zusammensetzungen richtet sich nach dem Applikationsverfahren und der gewünschten Schichtdicke; er liegt typischerweise zwischen 10 Gew.-% und 80 Gew.-%.

Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und die Art des Substrats (Schichtträger) sind vom gewünschten Applikationsgebiet abhängig. Der Schichtdickenbereich umfasst im allgemeinen Werte von ca. 1 µm bis ca. 20 µm, vorzugsweise 3-15 µm.

Nach dem Beschichten wird das Lösungsmittel in der Regel durch Trocknen entfernt, vorzugsweise bei Temperaturen zwischen 20 °C und 100 °C, und es resultiert eine Schicht der erfindungsgemässen Zusammensetzung auf dem Substrat.

Zur Herstellung von Reliefstrukturen wird das mit der erfindungsgemässen Zusammensetzung beschichtete Substrat mit aktinischer Strahlung bildmässig belichtet. Unter "aktinischer Strahlung" versteht man in der Regel UV- oder VIS-Strahlung, vorzugsweise im Wellenlängenbereich von 220-550 nm. Der Begriff 'bildmässige' Belichtung beinhaltet sowohl die Belichtung durch eine Photomaske, die ein vorbestimmtes Muster enthält, als auch die Belichtung durch einen Laserstrahl, der beispielsweise computergesteuert über die Oberfläche des beschichteten Substrates bewegt wird.

Als Strahlungsquellen können im Prinzip sämtliche Lampen verwendet werden, die Strahlung im UV- und/oder VIS-Bereich emittieren. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser. Mit Laserlicht kann der Resist auch ohne Maske belichtet werden, indem der gesteuerte Laser-Strahl direkt auf der Resist-Schicht schreibt. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Im Gegensatz zu vielen bekannten Positiv-Photoresist-Systemen auf Basis chemischer Amplifikation ist es bei Verwendung der erfindungsgemässen Zusammensetzungen überraschenderweise nicht notwendig, den Resist nach der Belichtung einer Wärmebehandlung, dem sogenannten "post exposure bake" zu unterziehen, um eine vollständige Reaktion der säureempfindlichen Gruppen im Polymergerüst mit der durch die Belichtung erzeugten Säure zu gewährleisten und flüchtige Reaktionsprodukte zu entfernen.

Falls erwünscht, kann eine solche Wärmebehandlung jedoch ohne nachteilige Folgen für die belichteten Strukturen vorgenommen werden.

Nach der in üblicher Weise erfolgten bildmässigen Belichtung des Materials werden die belichteten Stellen des Photolackes durch Herauslösen in einem Entwickler entfernt.

Die Wahl des jeweiligen Entwicklers richtet sich nach der Art des Photolackes, insbesondere nach der Natur des verwendeten Bindemittels oder der entstehenden Photolyseprodukte. Der Entwickler kann wässrige Lösungen von Basen umfassen, denen gegebenenfalls organische Lösungsmittel oder deren Mischungen zugesetzt wurden.

Besonders bevorzugt als Entwickler werden wässrig alkalische Lösungen, wie sie auch für die Entwicklung von Naphthochinondiazidschichten eingesetzt werden. Dazu zählen insbesondere wässrige Lösungen von Alkalimetallsilikaten, -phosphaten, -hydroxiden und -carbonaten. Diesen Lösungen können gegebenenfalls noch kleinere Mengen an Netz-mitteln und/oder organischen Lösungsmitteln zugesetzt sein.

Typische organische Lösungsmittel, die den Entwicklerflüssigkeiten zugesetzt werden können, sind beispielsweise Cyclohexanon, 2-Ethoxyethanol, Aceton, Isopropanol, Ethanol, sowie Mischungen zweier oder mehrerer dieser Lösungsmittel.

Die erfindungsgemässen strahlungsempfindlichen Zusammensetzungen eignen sich als Photoresists für die Elektronik, insbesondere als Ätzresist zur Herstellung von gedruckten Schaltungen oder als Mikroresist zur Herstellung von integrierten Schaltkreisen, sowie für die Herstellung von Druckplatten, wie z.B. Offsetdruckplatten.

Bei der bevorzugten Verwendung der erfindungsgemässen Zusammensetzungen als Ätzresist lässt sich das durch die Entwicklung freigelegte Metall, üblicherweise Kupfer, mit jedem bekannten Ätzmittel, wie beispielsweise Lösungen von Eisenchlorid, Wasserstoffperoxid/Phosphorsäure, Ammoniumpersulfat oder Kupferchlorid, entfernen.

Die verbliebene Photoresistschicht kann anschliessend durch Strippen mit starken wässrigen Basen, wie z.B. NaOH oder KOH, und/oder organischen Lösungsmitteln entfernt werden.

Einen weiteren Gegenstand der vorliegenden Erfindung bildet somit ein Verfahren zur Herstellung von Reliefstrukturen auf einer Leiterplatte, dadurch gekennzeichnet, dass ein Substrat mit einer Zusammensetzung nach Anspruch 1 beschichtet wird und der nach Entfernen des Lösungsmittels erhaltene Film bildmässig belichtet und anschliessend wässrig-alkalisch entwickelt wird.

Eine bevorzugte Ausführungsform der Erfindung ist ein Verfahren zur Herstellung von Reliefstrukturen, das durch folgende Verfahrensschritte gekennzeichnet ist:
(A) Beschichten eines kupferkaschierten Substrats mit einer Zusammensetzung gemäss Anspruch 1 mittels in der Applikation von Flüssigresists bekannten Verfahren;
(B) Entfernen des Lösungsmittels durch Trocknung bei Temperaturen zwischen 30 °C und 130 °C;
(C) Belichtung mit aktinischer Strahlung durch eine Maske oder mittels direkter Laserbestrahlung;
(D) Entwicklung mit wässrig-alkalischen oder semiwässrig-alkalischen Entwicklerlösungen;
(E) Ätzung mit sauren oder schwach alkalischen Ätzmitteln;
(F) Entfernung der verbliebenen Photoresistschicht durch Strippen mit starken wässrigen Basen und/oder organischen Lösungsmitteln.

Hervorzuheben ist die aussergewöhnlich gute thermische Lagerstabilität der einzelnen Komponenten sowie der daraus hergestellten Beschichtungen.
Durch geeignete Auswahl der Polymeren gemäss Komponenten (a) und (b) lassen sich auch die mechanischen Eigenschaften der Resistzusammensetzung in weiten Bereichen variieren. Beispielsweise kann durch Verwendung von Polymeren mit hoher Härte eine sehr hohe mechanische Beständigkeit erzielt werden.

### Beispiele

### I. Herstellung der Polymeren

### I.1. Poly-2-tetrahydropyranylmethacrylat

Eine Lösung von 10 g (59 mmol) 2-Tetrahydropyranylmethacrylat und 0,25 g Azoisobutyronitril (AIBN) in 15 g Methoxypropylacetat wird 8 h bei 80 °C unter Stickstoffatmosphäre gerührt. Die so erhaltene Lösung von Poly-2-tetrahydropyranylmethacrylat (Mₙ = 4435, M_{w} = 91593) kann direkt (ohne Isolierung des Polymeren) weiterverarbeitet werden.
Säuregehalt der Lösung: 0,033 mol/kg
Säuregehalt nach 9 Monaten bei Raumtemperatur: 0,040 mol/kg

### I.2. Copolymer aus 2-Tetrahydropyranylmethacrylat, Methylmethacrylat und 2-Ethylhexylmethacrylat

Analog zu Beispiel I.1. wird eine Lösung von 25,2 g (148 mmol) 2-Tetrahydropyranylmethacrylat, 10,4 g (104 mmol) Methylmethacrylat, 4,4 g (22 mmol) 2-Ethylhexylmethacrylat und 1 g Azoisobutyronitril in 60 g Methoxypropylacetat 8 h unter Stickstoff gerührt. Die so erhaltene Lösung des Copolymeren (Mₙ = 7237, M_{w} = 48154) kann direkt weiterverarbeitet werden.

### I.3. Copolymer aus 2-Tetrahvdropyranylmethacrylat, Methylmethacrylat und 2-Hydroxyethylmethacrylat

Zu einer Mischung von 6,3 g (37 mmol) 2-Tetrahydropyranylmethacrylat, 2,6 g (26 mmol) Methylmethacrylat, 1,1 g (9 mmol) 2-Hydroxyethylmethacrylat und 100 g Methoxypropylacetat wird unter Stickstoff bei 80 °C eine Lösung von 56,7 g (333 mmol) 2-Tetrahydropyranylmethacrylat, 23,4 g (234 mmol) Methylmethacrylat, 9,9 g (76 mmol) 2-Hydroxyethylmethacrylat und 2 g Azoisobutyronitril in 50 g Methoxypropylacetat innerhalb einer Stunde unter Rühren zugetropft. Das Gemisch wird weiter bei 80 °C gerührt, und eine Stunde nach der Zugabe werden weitere 0,5 g Azoisobutyronitril hinzugegeben.
Anschliessend wird die Lösung weitere 6 h bei 80 °C gerührt. Die so erhaltene Lösung des Copolymeren (Mₙ = 8103, M_{w} = 47096) kann direkt weiterverarbeitet werden.

### I.4. Copolymer aus 2-Tetrahydropyranylacrylat und Methylmethacrylat

Zu einer Mischung von 3,78 g (24 mmol) 2-Tetrahydropyranylacrylat, 2,22 g (22 mmol) Methylmethacrylat und 60 g Methoxypropylacetat wird unter Stickstoff bei 80 °C eine Lösung von 34,02 g (218 mmol) 2-Tetrahydropyranylacrylat, 19,98 g (200 mmol) Methylmethacrylat und 1,2 g Azoisobutyronitril in 30 g Methoxypropylacetat innerhalb 1,5 h unter Rühren zugetropft. Das Gemisch wird weiter bei 80 °C gerührt, und eine Stunde nach der Zugabe werden weitere 0,3 g Azoisobutyronitril hinzugegeben. Anschliessend wird die Lösung weitere 5,5 h bei 80 °C gerührt. Die so erhaltene Lösung des Copolymeren (Mₙ = 8108, M_{w} = 32167) kann direkt weiterverarbeitet werden.

### I.5. Copolymer aus Methacrylsäure, Methylmethacrylat und 2-Ethylhexylmethacrylat

Analog zu Beispiel I.1. wird eine Lösung von 4,0 g (47 mmol) Methacrylsäure, 12,0 g (120 mmol) Methylmethacrylat, 4,0 g (20 mmol) 2-Ethylhexylmethacrylat und 0,5 g Azoisobutyronitril in 30 g Isopropanol 8 h unter Stickstoff gerührt. Die so erhaltene Lösung des Copolymeren (Mₙ = 8691, M_{w} = 54540, Säuregehalt: 1,13 mol/kg) kann direkt weiterverarbeitet werden.

### I.6. Copolymer aus Methacrylsäure, Methylmethacrylat und tert.-Butylacrylat

Zu einer Mischung von 15,0 g (174 mmol) Methacrylsäure, 70 g (700 mmol) Methylmethacrylat, 15,0 g (117 mmol) tert.-Butylacrylat und 1000 g Isopropanol wird unter Stickstoff bei 80 °C eine Lösung von 135 g (1,568 mol) Methacrylsäure, 630 g (6,30 mol) Methylmethacrylat, 135 g (1,05 mol) tert.-Butylacrylat und 12,5 g Azoisobutyronitril in 500 g Isopropanol innerhalb 2 h unter Rühren zugetropft. Das Gemisch wird weiter bei 80 °C gerührt, und eine Stunde nach der Zugabe werden weitere 2,5 g Azoisobutyronitril hinzugegeben.
Anschliessend wird die Lösung weitere 5 h bei 80 °C gerührt. Die so erhaltene Lösung des Copolymeren (Mₙ = 8880, M_{w} = 27422, Säuregehalt: 0,75 mol/kg) kann direkt weiterverarbeitet werden.

### I.7. Copolymer aus 2-Tetrahydropyranylmethacrylat, Methylacrylat und 2-Hydroxyethylmethacrylat

Zu einer Mischung von 3,78 g (22 mmol) 2-Tetrahydropyranylmethacrylat, 1,56 g (18 mmol) Methylacrylat, 0,66 g (5 mmol) 2-Hydroxyethylmethacrylat und 60 g Methoxypropylacetat wird unter Stickstoff bei 70 °C eine Lösung von 34,02 g (200 mmol) 2-Tetrahydropyranylmethacrylat, 14,04 g (163 mmol) Methylacrylat, 5,94 g (46 mmol) 2-Hydroxyethylmethacrylat und 1,74 g Azoisobutyronitril in 30 g Methoxypropylacetat innerhalb von 6 Stunden unter Rühren zugetropft. Das Gemisch wird weiter bei 70 °C gerührt, und eine Stunde nach der Zugabe werden weitere 0,18 g Azoisobutyronitril hinzugegeben.
Anschliessend wird die Lösung eine weitere Stunde bei 70 °C gerührt. Die so erhaltene Lösung des Copolymeren (Mₙ = 9074, M_{w} = 44877) kann direkt weiterverarbeitet werden.

### I.8. Copolymer aus Methacrylsäure, Methylmethacrylat, Ethylacrylat und Methacrylamid

Zu einer Mischung von 3,0 g (35 mmol) Methacrylsäure, 11 g (110 mmol) Methylmethacrylat, 5,0 g (50 mmol) Ethylacrylat, 1,0 g (9 mmol) Methacrylamid und 200 g Methoxypropylacetat wird unter Stickstoff bei 80 °C eine Lösung von 27 g (314 mmol) Methacrylsäure, 99 g (990 mmol) Methylmethacrylat, 45 g (450 mmol) Ethylacrylat, 9,0 g (80 mmol) Methacrylamid und 2,5 g Azoisobutyronitril in 100 g Methoxypropylacetat innerhalb 2,25 h unter Rühren zugetropft. Das Gemisch wird weiter bei 80 °C gerührt, und eine Stunde nach der Zugabe werden weitere 0,5 g Azoisobutyronitril hinzugegeben.
Anschliessend wird die Lösung weitere 4,75 h bei 80 °C gerührt. Die so erhaltene Lösung des Copolymeren (Mₙ = 8547, M_{w} = 31820, Säuregehalt: 0,84 mol/kg) kann direkt weiterverarbeitet werden.

### I.9. Copolymer aus Methacrylsäure, Methylmethacrylat und Ethylacrylat

Zu einer Mischung von 3,0 g (35 mmol) Methacrylsäure, 11 g (110 mmol) Methylmethacrylat, 6,0 g (60 mmol) Ethylacrylat und 200 g Methoxypropylacetat wird unter Stickstoff bei 80 °C eine Lösung von 27 g (314 mmol) Methacrylsäure, 99 g (990 mmol) Methylmethacrylat, 54 g (540 mmol) Ethylacrylat und 2,5 g Azoisobutyronitril in 100 g Methoxypropylacetat innerhalb von 2 h unter Rühren zugetropft. Das Gemisch wird weiter bei 80 °C gerührt, und eine Stunde nach der Zugabe werden weitere 0,5 g Azoisobutyronitril hinzugegeben.
Anschliessend wird die Lösung weitere 5 h bei 80 °C gerührt. Die so erhaltene Lösung des Copolymeren (Mₙ = 8993, M_{w} = 43314, Säuregehalt: 0,7 mol/kg) kann direkt weiterverarbeitet werden.

### I.10. Copolymer aus Methacrylsäure, Methylmethacrylat und Ethylacrylat

Zu einer Mischung von 2,4 g (28 mmol) Methacrylsäure, 11,6 g (116 mmol) Methylmethacrylat, 6,0 g (60 mmol) Ethylacrylat und 200 g Methoxypropylacetat wird unter Stickstoff bei 80 °C eine Lösung von 21,6 g (251 mmol) Methacrylsäure, 104,4 g (1,04 mol) Methylmethacrylat, 54 g (540 mmol) Ethylacrylat und 4,0 g Azoisobutyronitril in 100 g Methoxypropylacetat innerhalb von 2 h unter Rühren zugetropft. Das Gemisch wird weiter bei 80 °C gerührt, und eine Stunde nach der Zugabe werden weitere 1,0 g Azoisobutyronitril hinzugegeben.
Anschliessend wird die Lösung weitere 5 h bei 80 °C gerührt. Die so erhaltene Lösung des Copolymeren (Mₙ =9275, M_{w} = 30304, Säuregehalt: 0,61 mol/kg) kann direkt weiterverarbeitet werden.

### I.11. Copolymer aus Methacrylsäure, Methylmethacrylat und N-Phenylmaleinimid

Zu einer Mischung von 4,0 g (26,5 mmol) Methacrylsäure, 14,0 g (140 mmol) Methylmethacrylat, 2,0 g (11,6 mmol) N-Phenylmaleinimid und 200 g Methoxypropylacetat wird unter Stickstoff bei 135 °C eine Lösung von 36,0 g (419 mmol) Methacrylsäure, 126 g (1,26 mol) Methylmethacrylat, 18 g (104 mmol) N-Phenylmaleinimid und 5,0 g Trigonox C (Produkt der Firma Akzo) in 100 g Methoxypropylacetat innerhalb von 2 h unter Rühren zugetropft.
Anschliessend wird die Lösung weitere 6 h bei 135 °C gerührt. Die so erhaltene Lösung des Copolymeren (Mₙ =3883, M_{w} = 10041, Säuregehalt: 0,933 mol/kg) kann direkt weiterverarbeitet werden.

### I.12. Copolymer aus 2-Tetrahydropyranylacrylat, Methylmethacrylat und 2-Dimethylaminoethylmethacrylat

Zu einer Mischung von 6,3 g (37 mmol) 2-Tetrahydropyranylmethacrylat, 3,67 g (36,7 mmol) Methylmethacrylat, 0,03 g (0,19 mmol) 2-Dimethylaminoethylmethacrylat und 100 g Methoxypropylacetat wird unter Stickstoff bei 70 °C eine Lösung von 56,7 g (333 mmol) 2-Tetrahydropyranylmethacrylat, 33,0 g (33 mmol) Methylmethacrylat, 0,27 g (1,72 mmol) 2-Dimethylaminoethylmethacrylat und 2,0 g Azoisobutyronitril in 50 g Methoxypropylacetat innerhalb von 2 h unter Rühren zugetropft. Das Gemisch wird weiter bei 70 °C gerührt, und eine Stunde nach der Zugabe werden weitere 0,5 g Azoisobutyronitril hinzugegeben.
Anschliessend wird die Lösung weitere 5 h bei 70 °C gerührt. Die so erhaltene Lösung des Copolymeren (Mₙ = 9334, M_{w} = 44050) kann direkt weiterverarbeitet werden.

### II. Anwendungsbeispiele

### II.1. Positiv-Ätzresist

Zu einem Gemisch aus 2 g der Lösung aus Beispiel I.1 und 3 g der Lösung aus Beispiel 1.6 wird eine Lösung aus 0,23 g des Photoinitiators Degacure® KI 85 (Degussa) und 0,04 g 9-Methylanthracen in 3 g Methoxypropylacetat hinzugegeben. Die so erhaltene Resistlösung wird filtriert und anschliessend mittels eines K-bar coaters (36 µm) auf ein kupferkaschiertes Substrat (18 µm Kupfer) aufgetragen. Das beschichtete Substrat wird 10 min bei Raumtemperatur und anschliessend 15 min bei 80 °C getrocknet, wobei ein Resistfilm von 9 µm Schichtdicke erhalten wird. Die Belichtung erfolgt durch einen PR 340 ORC Printer, SMX 7000H Lampe, wobei als Vorlage ein 21 Step Stouffer Sensitivity Guide (siehe W.S. DeForest, "Photoresist", McGraw-Hill Book Comp., N.Y., S. 109 ff.) verwendet wird. Die Belichtungsenergie beträgt 80 mJ/cm². Nach ca. 5 min wird die belichtete Platte 120 Sekunden lang mit einer 1%igen wässrigen Na₂CO₃-Lösung (30 °C) entwickelt (2 bar Sprühdruck). Nach Ätzen mit CuCl₂/HCl-Lösung bei 45 °C wird ein Reliefbild mit der letzen abgebildeten Stufe Nr. 4 erhalten. Strukturen von 50 µm sind gut aufgelöst.
Der Resist wird anschliessend durch Eintauchen in wässrige 5%-NaOH-Lösung bei 30 °C entfernt.

### II.2. Positiv-Ätzresist

Zu einem Gemisch aus 3,5 g der Lösung aus Beispiel I.2 und 1,5 g der Lösung aus Beispiel I.5 wird eine Lösung aus 0,23 g des Photoinitiators Degacure® KI 85 (Degussa) und 0,04 g 9-Methylanthracen in 3 g Methoxypropylacetat hinzugegeben. Die Beschichtung, Belichtung, Entwicklung und Ätzung erfolgen in gleicher Weise wie in Beispiel II.1.. Die Belichtungsenergie beträgt 80 mJ/cm². Die Entwicklungsdauer beträgt 120 s bei 22 °C und 2 bar Sprühdruck. Dabei wird ein Reliefbild mit der letzten abgebildeten Stufe Nr. 3 erhalten. Strukturen von 25 µm sind gut aufgelöst.

### II.3. Positiv-Ätzresist

Zu einem Gemisch aus 2,5 g der Lösung aus Beispiel I.2 und 2,5 g der Lösung aus Beispiel I.6 wird eine Lösung aus 0,23 g des Photoinitiators Degacure® KI 85 (Degussa) und 0,04 g 9-Methylanthracen in 3 g Methoxypropylacetat hinzugegeben. Die Beschichtung, Belichtung, Entwicklung und Ätzung erfolgen in gleicher Weise wie in Beispiel II.1.
Belichtungsenergie: 80 mJ/cm²
Entwicklungsdauer: 120 s (30 °C/2 bar Sprühdruck)
letzte abgebildete Stufe: Nr. 3
Auflösung: 25 µm

### II.4. Positiv-Ätzresist

Zu einem Gemisch aus 1,5 g der Lösung aus Beispiel I.2 und 4,67 g einer 30 %igen Lösung von Scripset 550 in Methoxypropylacetat wird eine Lösung aus 0,16 g des Photoinitiators Cyracure 6990 (Union Carbide) und 0,04 g Quantacure ITX (Octel Chemicals) in 1,83 g Methoxypropylacetat hinzugegeben. Die Beschichtung, Belichtung, Entwicklung und Ätzung erfolgen in gleicher Weise wie in Beispiel II.1.
Belichtungsenergie: 125 mJ/cm²
Entwicklungsdauer: 120 s (35 °C/1 bar Sprühdruck)
letzte abgebildete Stufe: Nr. 1
Auflösung: 25 µm
Ein Vergleichstest mit der Lösung aus Beispiel I.2. nach 9 Monaten Lagerung bei Raumtemperatur zeigt keinen Unterschied.

### II.5. Positiv-Ätzresist

Zu einem Gemisch aus 3,0 g der Lösung aus Beispiel I.3 und 2,0 g der Lösung aus Beispiel I.5 wird eine Lösung aus 0,16 g des Photoinitiators Cyracure 6990 (Union Carbide), 0,04 g Quantacure ITX (Octel Chemicals) und 0,01 g Orasolblau GN (Ciba) in 3 g Methoxypropylacetat hinzugegeben. Die Beschichtung, Belichtung, Entwicklung und Ätzung erfolgen in gleicher Weise wie in Beispiel II.1.
Belichtungsenergie: 150 mJ/cm²
Entwicklungsdauer: 100 s (30 °C/1 bar Sprühdruck)
letzte abgebildete Stufe: Nr. 2
Auflösung: 25 µm

### II.6. Positiv-Ätzresist

Zu einem Gemisch aus 2,5 g der Lösung aus Beispiel I.4 und 3,33 g einer 30 %igen Lösung von Scripset 550 in Methoxypropylacetat wird eine Lösung aus 0,16 g des Photoinitiators Cyracure 6990 (Union Carbide) und 0,04 g Quantacure ITX (Octel Chemicals) in 2,17 g Methoxypropylacetat hinzugegeben. Die Beschichtung, Belichtung, Entwicklung und Ätzung erfolgen in gleicher Weise wie in Beispiel II.1.
Belichtungsenergie: 30 mJ/cm²
Entwicklungsdauer: 63 s (30 °C/1 bar Sprühdruck)
letzte abgebildete Stufe: Nr. 3
Auflösung: 25 µm

### II.7. Positiv-Ätzresist

Zu einem Gemisch aus 7,0 g der Lösung aus Beispiel I.3 und 3,0 g der Lösung aus Beispiel I.8 wird eine Lösung aus 0,32 g des Photoinitiators Cyracure 6974 (Union Carbide), 0,08 g Quantacure ITX (Octel Chemicals), 0,04 g Pergascriptblau S-RB (Ciba), 0,02 g Triazin A ((PCAS) und 0,01 g Orasolblau GN (Ciba) in 6 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 114 mJ/cm²
Entwicklungsdauer: 70 s (30 °C/1 bar Sprühdruck)
letzte abgebildete Stufe: Nr. 2
Auflösung: 25 µm

### II.8. Positiv-Ätzresist

Zu einem Gemisch aus 50 g der Lösung aus Beispiel I.3 und 50 g der Lösung aus Beispiel I.9 wird eine Lösung aus 3,2 g des Photoinitiators Cyracure 6974 (Union Carbide), 0,8 g Quantacure ITX (Octel Chemicals), 0,4 g Pergascriptblau S-RB (Ciba), 0,2 g Triazin A ((PCAS) und 0,1 g Orasolblau GN (Ciba) in 22,7 g Methoxypropylacetat hinzugegeben. Die Beschichtung, Belichtung, Entwicklung und Ätzung erfolgen in gleicher Weise wie in Beispiel II.1., jedoch wird bei der Beschichtung ein 64 g Roller Coater und zur Belichtung eine Staub-Lampe LB 65-1/5000 W verwendet.
Belichtungsenergie: 114 mJ/cm²
Entwicklungsdauer: 80 s (30 °C/1 bar Sprühdruck)
letzte abgebildete Stufe: Nr. 3
Auflösung: 25 µm

### II.9. Positiv-Ätzresist

Zu einem Gemisch aus 3,0 g der Lösung aus Beispiel I.3 und 7,0 g der Lösung aus Beispiel I.10 wird eine Lösung aus 0,32 g des Photoinitiators Cyracure 6974 (Union Carbide), 0,08 g Quantacure ITX (Octel Chemicals), 0,04 g Pergascriptblau S-RB (Ciba), 0,02 g Triazin A ((PCAS) und 0,01 g Orasolblau GN (Ciba) in 6 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 114 mJ/cm²
Entwicklungsdauer: 70 s (30 °C/1 bar Sprühdruck)
letzte abgebildete Stufe: Nr. 1
Auflösung: 25 µm

### II.10. Positiv-Ätzresist

Zu einem Gemisch aus 5,0 g der Lösung aus Beispiel I.7 und 5,0 g der Lösung aus Beispiel I.10 wird eine Lösung aus 0,32 g des Photoinitiators Cyracure 6974 (Union Carbide), 0,08 g Quantacure ITX (Octel Chemicals), 0,04 g Pergascriptblau S-RB (Ciba), 0,02 g Triazin A ((PCAS) und 0,01 g Orasolblau GN (Ciba) in 6 g Methoxypropylacetat hinzugegeben. Die Beschichtung, Belichtung, Entwicklung und Ätzung erfolgen in gleicher Weise wie in Beispiel II,1., jedoch wird zur Belichtung eine Staub-Lampe LB 65-1/5000 W verwendet.
Belichtungsenergie: 130 mJ/cm²
Entwicklungsdauer: 70 s (30 °C/1 bar Sprühdruck)
letzte abgebildete Stufe: Nr. 4
Auflösung: 25 µm

### II.11. Positiv-Ätzresist

Zu einem Gemisch aus 5,0 g der Lösung aus Beispiel I.4 und 5,0 g der Lösung aus Beispiel I.11 wird eine Lösung aus 0,32 g des Photoinitiators Cyracure 6974 (Union Carbide), 0,08 g Quantacure ITX (Octel Chemicals), 0,09 g Multiflow (Monsanto) und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 130 mJ/cm²
Entwicklungsdauer: 100 s (25 °C/1 bar Sprühdruck)
letzte abgebildete Stufe: Nr. 4
Auflösung: 25 µm

### II.12. Positiv-Ätzresist

Zu einem Gemisch aus 5,0 g der Lösung aus Beispiel I.4 und 5,0 g der Lösung aus Beispiel I.11 wird eine Lösung aus 0,32 g des Photoinitiators Cyracure 6974 (Union Carbide), 0,08 g Quantacure ITX (Octel Chemicals), 0,09 g Multiflow (Monsanto), 0,63 mg N-Methylimidazol und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 200 mJ/cm²
Entwicklungsdauer: 40 s (30 °C/1 bar Sprühdruck)
letzte abgebildete Stufe: Nr. 3
Auflösung: 25 µm

### II.13. Positiv-Ätzresist

Zu einem Gemisch aus 5,0 g der Lösung aus Beispiel I.4 und 5,0 g der Lösung aus Beispiel I.11 wird eine Lösung aus 0,32 g des Photoinitiators Cyracure 6974 (Union Carbide), 0,08 g Quantacure ITX (Octel Chemicals), 0,09 g Multiflow (Monsanto), 6,3 mg N-Methylimidazol und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 200 mJ/cm²
Entwicklungsdauer: 70 s (35 °C/1 bar Sprühdruck)
letzte abgebildete Stufe: Nr. 3
Auflösung: 25 µm

### II.14. Positiv-Ätzresist

Zu einem Gemisch aus 4,0 g der Lösung aus Beispiel I.7 und 6,0 g der Lösung aus Beispiel I.11 wird eine Lösung aus 0,32 g des Photoinitiators Cyracure 6974 (Union Carbide), 0,08 g Quantacure ITX (Octel Chemicals), 0,04 g Pergascriptblau S-RB (Ciba), 0,2 g Triazin A ((PCAS) und 0,01 g Orasolblau GN (Ciba) in 6 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 130 mJ/cm²
Entwicklungsdauer: 60 s (30 °C/1 bar Sprühdruck)
letzte abgebildete Stufe: Nr. 5
Auflösung: 25 µm

### II.15. Positiv-Ätzresist

Zu einem Gemisch aus 4,0 g der Lösung aus Beispiel I.7 und 6,0 g der Lösung aus Beispiel I.11 wird eine Lösung aus 0,16 g des Photoinitiators 9,10-Dihydroxy-2-Anthracensulfonsäure-(4-nitrophenyl)methylester, 0,4 g Pergascriptblau S-RB (Ciba), 0,2 g Triazin A ((PCAS) und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 130 mJ/cm²
Entwicklungsdauer: 70 s (30 °C/1 bar Sprühdruck)
letzte abgebildete Stufe: Nr. 2
Auflösung: 25 µm

### II.16. Positiv-Ätzresist

Zu einem Gemisch aus 5,0 g der Lösung aus Beispiel I.11 und 5,0 g der Lösung aus Beispiel I.12 wird eine Lösung aus 0,32 g des Photoinitiators Cyracure 6974 (Union Carbide), 0,08 g Quantacure ITX (Octel Chemicals), 0,09 g Multiflow (Monsanto) und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 200 mJ/cm²
Entwicklungsdauer: 135 s (35 °C/1 bar Sprühdruck)
letzte abgebildete Stufe: Nr. 2
Auflösung: 25 µm

### II.17. Positiv-Ätzresist

Zu einem Gemisch aus 5,0 g der Lösung aus Beispiel I.11 und 5,0 g der Lösung aus Beispiel I.12 wird eine Lösung aus 0,16 g des Photoinitiators Diphenyliodonium-hexafluoroarsenat 0,08 g Quantacure ITX (Octel Chemicals), 0,09 g Multiflow (Monsanto) und 0,01 g Orasolblau GN (Ciba) in 5,7 g Methoxypropylacetat hinzugegeben. Die Beschichtung, Belichtung, Entwicklung und Ätzung erfolgen in gleicher Weise wie in Beispiel II.1., jedoch wird zur Belichtung eine Staub-Lampe LB 65-1/5000 W verwendet.
Belichtungsenergie: 130 mJ/cm²
Entwicklungsdauer: 70 s (30 °C/1 bar Sprühdruck)
letzte abgebildete Stufe: Nr. 5
Auflösung: 25 µm

## Patentansprüche

1. Wässrig-alkalisch entwickelbare Positiv-Photoresist-Zusammensetzung enthaltend
(a) mindestens ein Homo- oder Copolymer enthaltend 8-100 Gew.-% wiederkehrende Strukturelemente der Formel Ia und 92-0 Gew.-% wiederkehrende Strukturelemente der Formel Ib 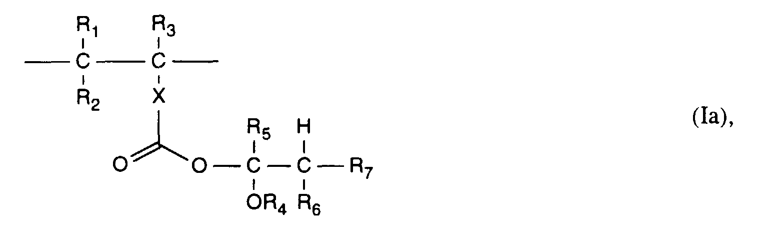 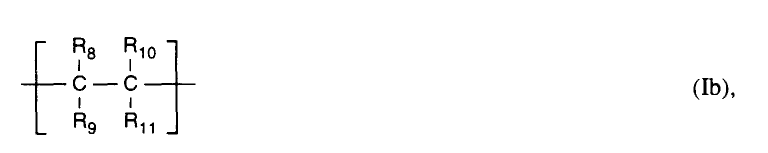 worin X für eine direkte Bindung oder eine zweiwertige organische Gruppe mit 1-18 C-Atomen steht, wobei ein oder mehrere C-Atome durch Sauerstoff-, Schwefel- oder nicht-basische Stickstoff-Atome ersetzt sein können,
R₁, R₂ und R₃ unabhängig voneinander Wasserstoff, C₁-C₆-Alkyl, C₅-C₁₄-Aryl, C₆-C₂₀-Aralkyl, Halogen, -COOH, -COOR₁₂ oder -CONR₁₃R₁₄ bedeuten, wobei R₁₂ für eine unsubstituierte oder eine mit C₁-C₆-Alkoxy, Hydroxy oder Halogen substituierte C₁-C₁₈-Alkylgruppe oder den Rest eines hydroxyterminierten Polyethers oder Polyesters steht, R₁₃ und R₁₄ unabhängig voneinander Wasserstoff, C₁-C₁₈-Alkyl, C₅-C₁₄-Aryl oder C₆-C₂₀-Aralkyl bedeuten, R₄ C₁-C₆-Alkyl oder Phenyl darstellt,
R₅ Wasserstoff oder C₁-C₆-Alkyl ist und
R₆ und R₇ unabhängig voneinander Wasserstoff, C₁-C₆-Alkyl oder C₁-C₆-Alkoxy darstellen,
oder zwei der Reste R₄, R₅, R₆ oder R₇ zusammen mit den C- oder O-Atomen, an die sie gebunden sind, einen Ring mit 5-8 Ringgliedern bilden,
R₈, R₉ , R₁₀ und R₁₁ unabhängig voneinander Wasserstoff, C₁-C₁₈-Alkyl, unsubstituiertes oder mit C₁-C₆-Alkyl, C₁-C₆-Alkoxy oder Halogen substituiertes Phenyl, Halogen, C₁-C₁₈-Alkoxy, -COOR₁₂, -OCOR₁₂ oder -COOH bedeuten,
worin R₁₂ die oben angegebene Bedeutung hat,
oder R₉ und R₁₁ zusammen mit den C-Atomen, an die sie gebunden sind, einen fünfgliedrigen Ring der Struktur 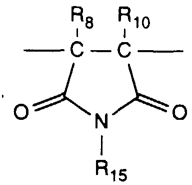 bilden, worin R₁₅ Wasserstoff, C₁-C₁₈-Alkyl, C₅-C₁₄-Aryl, C₆-C₂₀-Aralkyl oder hydroxy-, alkoxy- oder halogensubstituiertes Phenyl bedeutet,
mit der Massgabe, dass das mittlere Molekulargewicht (Gewichtsmittel) des Homo- oder Copolymeren 1000-500000 und die Menge an COOH-Gruppen höchstens 0,4 mol/kg beträgt,
(b) mindestens ein Carbonsäuregruppen enthaltendes Copolymer, worin der Gehalt an Carbonsäuregruppen 0,40 bis 5,50 mol/kg beträgt,
(c) mindestens eine unter der Einwirkung von aktinischer Strahlung säurebildende Verbindung und
(d) ein organisches Lösungsmittel.

2. Zusammensetzung nach Anspruch 1 enthaltend als Komponente (a) mindestens ein Homo- oder Copolymer enthaltend wiederkehrende Strukturelemente der Formel Ia, worin R₁ und R₂ Wasserstoff bedeuten und R₃ für Wasserstoff oder Methyl steht.

3. Zusammensetzung nach Anspruch 1 enthaltend als Komponente (a) mindestens ein Homo- oder Copolymer enthaltend wiederkehrende Strukturelemente der Formel III 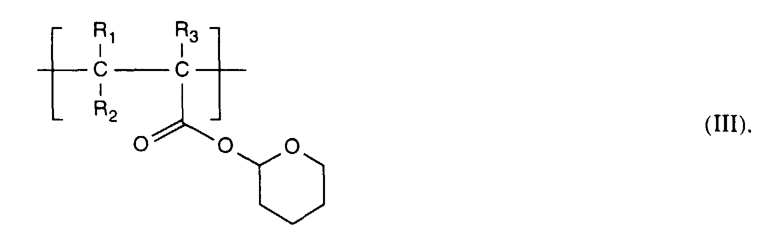 worin R₁, R₂ und R₃ die in Anspruch 1 angegebene Bedeutung haben.

4. Zusammensetzung nach Anspruch 3 enthaltend als Komponente (a) mindestens ein Homo- oder Copolymer enthaltend wiederkehrende Strukturelemente der Formel III, worin R₁ und R₂ Wasserstoff bedeuten und R₃ für Wasserstoff oder Methyl steht.

5. Zusammensetzung nach Anspruch 1 enthaltend als Komponente (b) mindestens ein Homo- oder Copolymer enthaltend 5-40 Gew.-% wiederkehrende Struktureinheiten der Formel IIa und 95-60 Gew.-% wiederkehrende Struktureinheiten der Formel IIb 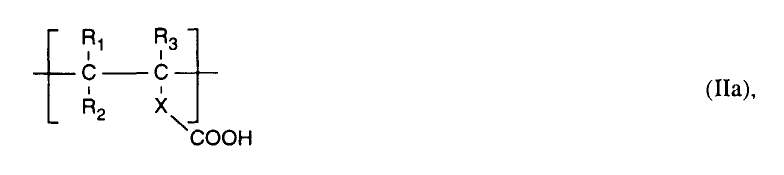 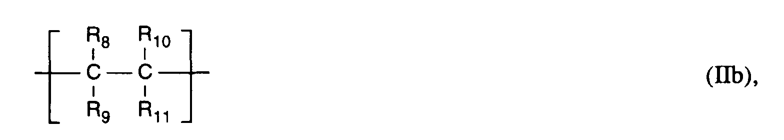 worin R₁, R₂, R₃, R₈, R₉, R₁₀, R₁₁ und X die in Anspruch 1 angegebene Bedeutung haben mit der Massgabe, dass das mittlere Molekulargewicht des Copolymeren (Gewichtsmittel) 1000-500000 Dalton und der Gehalt an Carbonsäuregruppen 0,40 bis 5,50 mol/kg beträgt.

6. Zusammensetzung nach Anspruch 5, enthaltend als Komponente (b) mindestens ein Homo- oder Copolymer enthaltend wiederkehrende Struktureinheiten der Formel (IIa), worin R₁ und R₂ Wasserstoff bedeuten, R₃ für Wasserstoff oder Methyl steht und X eine direkte Bindung ist.

7. Zusammensetzung nach Anspruch 5, enthaltend als Komponente (b) mindestens ein Copolymer enthaltend wiederkehrende Struktureinheiten der Formel (IIb), worin R₈ und R₉ Wasserstoff bedeuten, R₁₀ für Wasserstoff oder Methyl steht, und R₁₁ Phenyl oder -COOR₁₂bedeutet, worin R₁₂ für C₁-C₁₈-Alkyl steht,
oder mindestens ein Copolymer enthaltend wiederkehrende Struktureinheiten der Formel 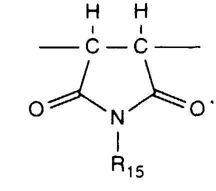 worin R₁₅ für Phenyl steht.

8. Zusammensetzung nach Anspruch 1 enthaltend als Komponente (a) mindestens ein Homo- oder Copolymer enthaltend 20-100 Gew.-% wiederkehrende Strukturelemente der Formel Ia und 80-0 Gew.-% wiederkehrende Strukturelemente der Formel Ib.

9. Zusammensetzung nach Anspruch 5, enthaltend als Komponente (b) mindestens ein Copolymer enthaltend 5-35 Gew.-% wiederkehrende Struktureinheiten der Formel IIa und 95-65 Gew.-% wiederkehrende Struktureinheiten der Formel IIb.

10. Zusammensetzung nach Anspruch 1, enthaltend 10-95 Gew.-% der Komponente (a) und 90-5 Gew.-% der Komponente (b), bezogen auf die Summe der Komponenten (a) + (b).

11. Zusammensetzung nach Anspruch 1, enthaltend als Komponente (c) ein photoempfindliches Diazonium-, Sulfonium-, Sulfoxonium- oder Iodoniumsalz oder einen photoempfindlichen Sulfonsäureester.

12. Zusammensetzung nach Anspruch 1, enthaltend als Komponente (c) Triphenylsulfoniumtrifluormethansulfonat, Triphenylsulfoniumhexafluoroantimonat, Triphenylsulfoniumhexafluorophosphat. Triphenylsulfoniumhexafluoroarsenat oder ein Hexafluorophosphat oder Hexafluoroantimonat der folgenden Sulfonium-Ionen: 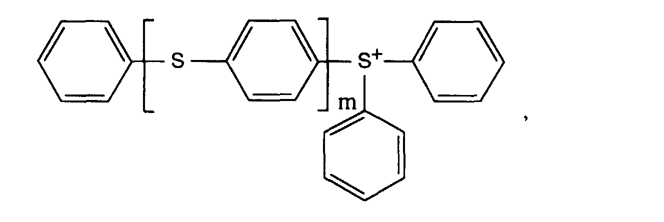 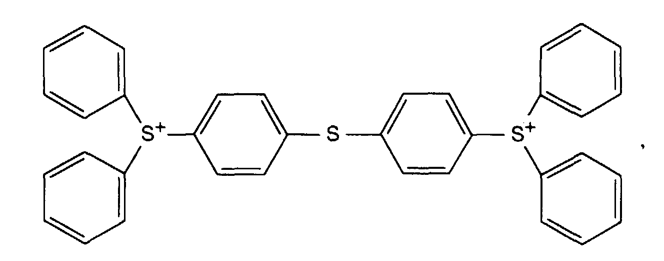 worin m für eine ganze Zahl von 1 bis 10 steht.

13. Zusammensetzung nach Anspruch 1, enthaltend als Komponente (d) Methoxypropylacetat.

14. Verfahren zur Herstellung von Reliefstrukturen auf einer Leiterplatte, dadurch gekennzeichnet, dass ein Substrat mit einer Zusammensetzung nach Anspruch 1 beschichtet wird und der nach Entfernen des Lösungsmittels erhaltene Film bildmässig belichtet und anschliessend wässrig-alkalisch entwickelt wird.

15. Verfahren nach Anspruch 14, das durch folgende Verfahrensschritte gekennzeichnet ist:
(A) Beschichten eines kupferkaschierten Substrats mit einer Zusammensetzung gemäss Anspruch 1 mittels in der Applikation von Flüssigresists bekannten Verfahren;
(B) Entfernen des Lösungsmittels durch Trocknung bei Temperaturen zwischen 30 °C und 130 °C;
(C) Belichtung mit aktinischer Strahlung durch eine Maske oder mittels direkter Laserbestrahlung;
(D) Entwicklung mit wässrig-alkalischen oder semiwässrig-alkalischen Entwicklerlösungen;
(E) Ätzung mit sauren oder schwach alkalischen Ätzmitteln;
(F) Entfernung der verbliebenen Photoresistschicht durch Strippen mit starken wässrigen Basen und/oder organischen Lösungsmitteln.

## Claims

1. A positive photoresist composition which can be developed in aqueous-alkaline media, comprising
(a) at least one homopolymer or copolymer comprising 8-100% by weight of recurring structural units of the formula Ia and 92-0% by weight of recurring structural units of the formula Ib 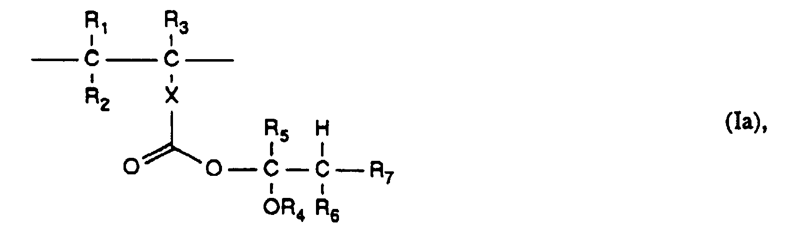 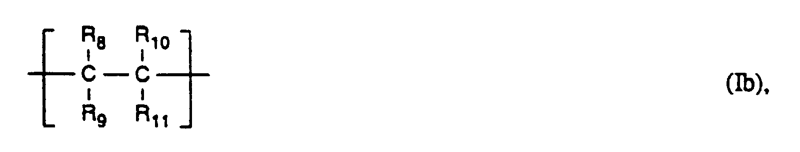 in which X is a direct bond or a divalent organic group having 1-18 carbon atoms, in which one or more carbon atoms may be replaced by oxygen, sulfur or non-basic nitrogen atoms, R₁, R₂ and R₃, independently of one another are hydrogen, C₁-C₆alkyl, C₅-C₁₄aryl, C₆-C₂₀aralkyl, halogen, -COOH, -COOR₁₂ or -CONR₁₃R₁₄, where R₁₂ is an unsubstituted or C₁-C₆alkoxy-, hydroxyl- or halogen-substituted C₁-C₁₈alkyl group or the radical of a hydroxyl-terminated polyether or polyester, and R₁₃ and R₁₄, independently of one another, are hydrogen, C₁-C₁₈alkyl, C₅-C₁₄aryl or C₆-C₂₀aralkyl,
R₄ is C₁-C₆alkyl or phenyl,
R₅ is hydrogen or C₁-C₆alkyl, and
R₆ and R₇, independently of one another, are hydrogen, C₁-C₆alkyl or C₁-C₆alkoxy,
or two of the radicals R₄, R₅, R₆ or R₇, together with the carbon or oxygen atoms to which they are bonded, form a 5- to 8-membered ring,
R₈, R₉, R₁₀ and R₁₁, independently of one another, are hydrogen, C₁-C₁₈alkyl, unsubstituted or C₁-C₆-alkyl-, C₁-C₆alkoxy- or halogen-substituted phenyl, halogen, C₁-C₁₈alkoxy, -COOR₁₂, -OCOR₁₂ or -COOH, in which R₁₂ is as defined above, or R₉ and R₁₁ together with the carbon atoms to which they are bonded, form a five-membered ring having the structure 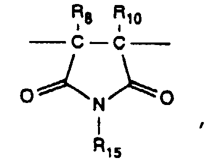 in which R₁₅ is hydrogen, C₁-C₁₈alkyl, C₅-C₁₄aryl, C₆-C₂₀aralkyl or hydroxyl-, alkoxy- or halogen-substituted phenyl,
with the proviso that the mean molecular weight (weight average) of the homopolymer or copolymer is 1000-500,000 and the amount of COOH groups is at most 0.4 mol/kg,
(b) at least one carboxyl-containing copolymer in which the content of carboxyl groups is from 0.40 to 5.50 mol/kg,
(c) at least one compound which forms an acid on exposure to actinic radiation, and
(d) an organic solvent.

2. A composition according to claim 1, wherein component (a) is at least one homopolymer or copolymer comprising recurring structural units of the formula Ia in which R₁ and R₂ are hydrogen and R₃ is hydrogen or methyl.

3. A composition according to claim 1, wherein component (a) is at least one homopolymer or copolymer comprising recurring structural units of the formula III 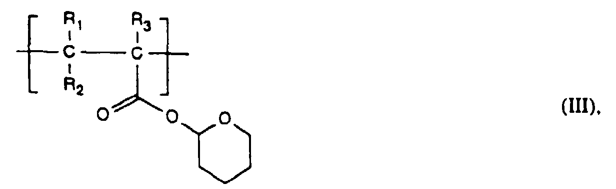 in which
R₁, R₂ and R₃, are as defined in claim 1.

4. A composition according to claim 3, wherein component (a) is at least one homopolymer or copolymer comprising recurring structural units of the formula III in which R₁ and R₂ are hydrogen and R₃ is hydrogen or methyl.

5. A composition according to claim 1, wherein component (b) is at least one homopolymer or copolymer comprising 5-40% by weight of recurring structural units of the formula IIa and 95-60% by weight of recurring structural units of the formula IIb 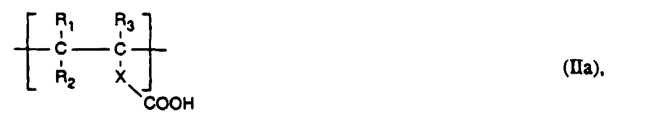 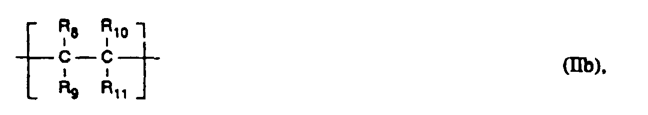 in which R₁, R₂, R₃, R₈, R₉, R₁₀, R₁₁ and X are as defined in claim 1, with the proviso that the mean molecular weight (weight average) of the copolymer is 1000-500,000 daltons and the content of carboxyl groups is from 0.40 to 5.50 mol/kg.

6. A composition according to claim 5, wherein component (b) is at least one homopolymer or copolymer comprising recurring structural units of the formula (IIa), in which R₁ and R₂ are hydrogen, R₃ is hydrogen or methyl and X is a direct bond.

7. A composition according to claim 5, wherein component (b) is at least one copolymer comprising recurring structural units of the formula (IIb) in which R₈ and R₉ are hydrogen, R₁₀ is hydrogen or methyl and R₁₁ is phenyl or -COOR₁₂, in which R₁₂ is C₁-C₁₈alkyl, or at least one copolymer comprising recurring structural units of the formula 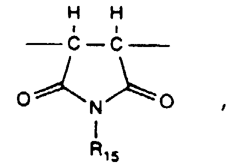 in which R₁₅ is phenyl.

8. A composition according to claim 1, wherein component (a) is at least one homopolymer or copolymer comprising 20-100% by weight of recurring structural units of the formula Ia and 80-0% by weight of recurring structural units of the formula Ib.

9. A composition according to claim 5, wherein component (b) is at least one copolymer comprising 5-35% by weight of recurring structural units of the formula IIa and 95-65% by weight of recurring structural units of the formula IIb.

10. A composition according to claim 1, comprising 10-95% by weight of component (a) and 90-5% by weight of component (b), based on the sum of components (a) + (b).

11. A composition according to claim 1, wherein component (c) is a photosensitive diazonium, sulfonium, sulfoxonium or iodonium salt or a photosensitive sulfonic acid ester.

12. A composition according to claim 1, wherein component (c) is triphenylsulfonium trifluoromethanesulfonate, triphenylsulfonium hexafluoroantimonate, triphenylsulfonium hexafluorophosphate, triphenylsulfonium hexafluoroarsenate or a hexafluorophosphate or hexafluoroantimonate of the following sulfonium ions: 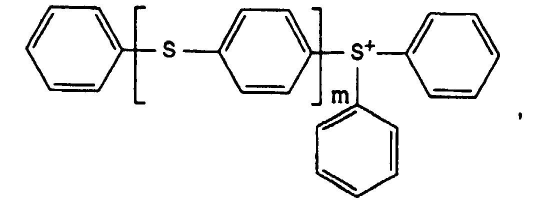 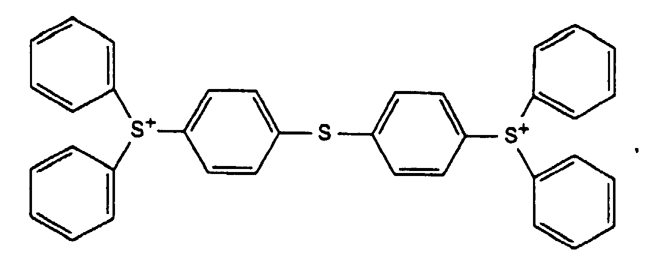 in which m is an integer from 1 to 10.

13. A composition according to claim 1, wherein component (d) is methoxypropyl acetate.

14. A process for the production of relief structures on a circuit board, which comprises coating a substrate with a composition according to claim 1, and exposing the film obtained after removal of the solvent imagewise and subsequently developing the exposed film in an aqueous-alkaline medium.

15. A process according to claim 14, which comprises the following steps:
(A) coating a copper-laminated substrate with a composition according to claim 1 by application of liquid resists by known methods;
(B) removal of the solvent by drying at temperatures of from 30°C to 130°C;
(C) exposure to actinic radiation through a mask or by means of direct laser irradiation;
(D) development using aqueous-alkaline or semiaqueous-alkaline developer solutions;
(E) etching with acidic or weakly alkaline etchants;
(F) removal of the photoresist coating which remains by stripping with strong aqueous bases and/or organic solvents.

## Revendications

1. Composition de photorésist positif développable en milieu aqueux-alcalin constituée par
(a) au moins un homo- ou copolymère ayant une teneur de 8 à 100% en masse en motifs de structure récurrents de formule la et de 90 à 0% en masse en motifs de structure récurrents de formule Ib 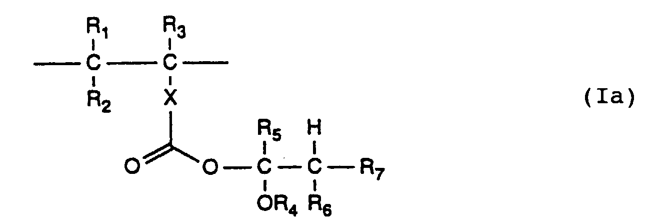 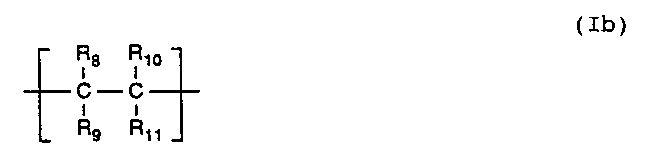 où
X représente une liaison directe ou un groupe organique bivalent présentant 1 à 18 atomes de carbone, un ou plusieurs atomes de carbone pouvant être remplacés par des atomes d'oxygène, de soufre ou d'azote non basique,
R₁, R₂ et R₃ représentent, indépendamment les uns des autres, des atomes d'hydrogène, des groupes alkyle en C₁-C₆, aryle en C₅-C₁₄, aralkyle en C₆-C₂₀, des atomes d'halogène, des groupes -COOH, -COOR₁₂ ou -CONR₁₃R₁₄, R₁₂ représentant un groupe alkyle en C₁-C₁₈ non substitué ou substitué par des substituants alkoxy en C₁-C₆, hydroxy ou halogène ou représente le reste d'un polyéther ou polyester présentant un groupe hydroxy terminal,
R₁₃ et R₁₄ représentent, indépendamment l'un de l'autre, des atomes d'hydrogène, des groupes alkyle en C₁-C₁₈, aryle en C₅-C₁₄ ou aralkyle en C₆-C₂₀,
R₄ représente un groupe alkyle en C₁-C₆ ou phényle,
R₅ représente un atome d'hydrogène ou un groupe alkyle en C₁-C₆ et
R₆ et R₇ représentent, indépendamment l'un de l'autre, des atomes d'hydrogène, des groupes alkyle en C₁-C₆ ou alkoxy en C₁-C₆,
ou deux des restes R₄, R₅, R₆ ou R₇ conjointement avec les atomes de C ou de O, auxquels ils sont liés, forment un cycle à 5-8 chaînons,
R₈, R₉, R₁₀ et R₁₁ représentent, indépendamment les uns des autres, des atomes d'hydrogène, des groupes alkyle en C₁-C₁₈, phényle non substitué ou substitué par des substituants alkyle en C₁-C₆, alkoxy en C₁-C₆ ou halogène, des atomes d'halogènes, des groupes alkoxy en C₁-C₁₈, -COOR₁₂, -OCOR₁₂ ou -COOH, où R₁₂ possède la signification donnée ci-dessus, ou
R₉ et R₁₁ forment, conjointement avec les atomes de carbone auxquels ils sont liés, un cycle à 5 chaînons répondant à la structure 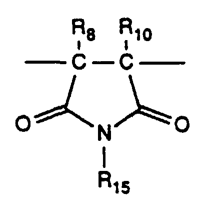 où R₁₅ représente un atome d'hydrogène, des groupes alkyle en C₁-C₁₈, aryle en C₅-C₁₄, aralkyle en C₆-C₂₀ ou phényle substitué par des substituants hydroxy, alkoxy ou halogène,
à la condition que la masse molaire moyenne (moyenne en poids) de l'homo- ou du copolymère soit de 1000-500000 et la quantité de groupes COOH soit de 0,4 mole/kg au maximum,
(b) au moins un copolymère présentant des groupes acide carboxylique, où la teneur en groupes acide carboxylique est de 0,40 à 5,50 mole/kg,
(c) au moins un composé générateur d'acide sous l'effet d'un rayonnement actinique et
(d) un solvant organique.

2. Composition selon la revendication 1, contenant en tant que composant (a) au moins un homo- ou copolymère présentant des motifs de structure récurrents de formule Ia, où R₁ et R₂ représentent des atomes d'hydrogène et R₃ représente un atome d'hydrogène ou un groupe méthyle.

3. Composition selon la revendication 1, contenant en tant que composant (a) au moins un homo- ou copolymère contenant des motifs de structure récurrents de formule III 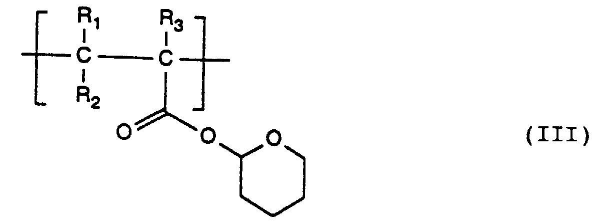 où R₁, R₂ et R₃ possèdent la signification donnée à la revendication 1.

4. Composition selon la revendication 3, contenant en tant que composant (a) au moins un homo- ou copolymère présentant des motifs de structure récurrents de formule III, dans laquelle R₁ et R₂ représentent un atome d'hydrogène et R₃ représente un atome d'hydrogène ou un groupe méthyle.

5. Composition selon la revendication 1, contenant en tant que composant (b) au moins un homo- ou copolymère ayant une teneur de 5 à 40% en masse en motifs de structure récurrents de formule IIa et de 95 à 60% en masse en motifs de structure récurrents de formule IIb 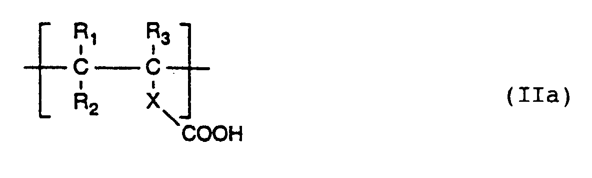 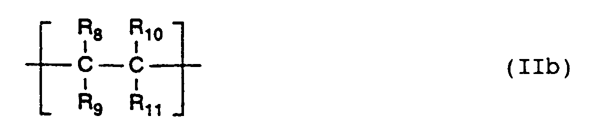 où R₁, R₂, R₃, R₈, R₉, R₁₀, R₁₁ et X possèdent la signification donnée à la revendication 1, à la condition que la masse molaire moyenne du copolymère (moyenne en poids) soit de 1000 à 500000 daltons et la teneur en groupes acide carboxylique de 0,40 à 5,50 moles/kg.

6. Composition selon la revendication 5, contenant en tant que composant (b) au moins un homo- ou copolymère présentant des motifs de structure récurrents de formule (IIa), où R₁ et R₂ représentent des atomes d'hydrogène, R₃ représente un atome d'hydrogène ou un groupe méthyle et X représente une liaison directe.

7. Composition selon la revendication 5, contenant en tant que composant (b) au moins un copolymère présentant des motifs de structure récurrents de formule (IIb), où R₈ et R₉ représentent des atomes d'hydrogène, R₁₀ représente un atome d'hydrogène ou un groupe méthyle, et R₁₁ représente un groupe phényle ou -COOR₁₂, où R₁₂ représente un groupe alkyle en C₁-C₁₈,
ou au moins un copolymère présentant des motifs de structure récurrents de formule 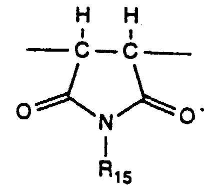 où R₁₅ représente un groupe phényle.

8. Composition selon la revendication 1, contenant en tant que composant (a) au moins un homo- ou copolymère ayant une teneur de 20 à 100% en masse en motifs de structure récurrents de formule Ia et de 80 à 0% en masse de motifs en motifs de structure récurrents de formule Ib.

9. Composition selon la revendication 5, contenant en tant que composant (b) au moins un copolymère ayant une teneur de 5 à 35% en masse en motifs de structure récurrents de formule IIa et de 95 à 65% en masse en motifs de structure récurrents de formule IIb.

10. Composition selon la revendication 1, ayant une teneur de 10 à 95% en masse en composant (a) et de 90 à 5% en masse en composant (b), par rapport à la somme des composants (a) + (b).

11. Composition selon la revendication 1, contenant en tant que composant (c) un sel photosensible de diazonium, de sulfonium, de sulfoxonium ou d'iodonium ou un ester photosensible de l'acide sulfanique.

12. Composition selon la revendication 1, contenant en tant que composant (c) le trilfuorométhanesulfonate de triphénylsulfonium, l'hexafluoroantimoniate de triphénylsulfonium, l'hexafluorophosphate de triphénylsulfonium, l'hexafluoroarséniate de triphénylsulfonium ou un hexafluorophosphate ou hexafluoroantimoniate des ions sulfonium suivants : 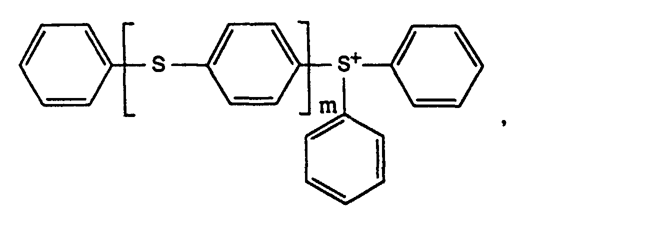 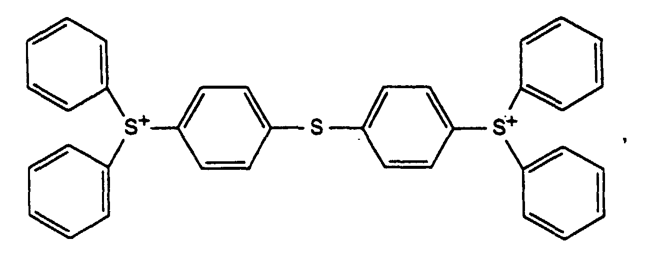 où m est un entier de 1 à 10.

13. Composition selon la revendication 1, contenant l'acétate de méthoxypropyle en tant que composant (d).

14. Procédé de préparation de structures en relief sur un circuit imprimé, caractérisé en ce qu'on revêt un substrat d'une composition selon la revendication 1 et, après avoir éliminé le solvant, on irradie le film selon modèle et on le développe ensuite en milieu aqueux-alcalin.

15. Procédé selon la revendication 14, caractérisé par les étapes de procédé suivantes :
(A) revêtement d'un substrat plaqué de cuivre d'une composition selon la revendication 1 au moyen de procédés connus pour l'application de résists liquides ;
(B) élimination du solvant par séchage à une température comprise entre 30 et 130°C ;
(C) irradiation par un rayonnement actinique à travers un masque ou directement par des rayons laser ;
(D) développement dans un révélateur aqueux-alcalin ou semi-aqueux-alcalin ;
(E) décapage avec des agents décapants acides ou faiblement alcalins ;
(F) élimination de la couche de photorésist restante par stripping avec des bases fortes et/ou solvants organiques.
